(19) Europäisches Patentamt
European Patent Office
Office européen des brevets

(11) Publication number: **0 087 305**
**B1**

(12) **EUROPEAN PATENT SPECIFICATION**

(45) Date of publication of patent specification: **11.05.88**

(51) Int. Cl.⁴: **C 08 J 5/18**

(21) Application number: **83300886.5**

(22) Date of filing: **21.02.83**

(54) **Process for production of aromatic polyimide film.**

(30) Priority: **23.02.82 JP 27729/82**

(43) Date of publication of application:
**31.08.83 Bulletin 83/35**

(45) Publication of the grant of the patent:
**11.05.88 Bulletin 88/19**

(84) Designated Contracting States:
**DE FR GB NL**

(56) References cited:
**GB-A- 903 272**
**GB-A-1 155 541**
**GB-A-2 070 509**
**US-A-3 961 009**

(73) Proprietor: **TORAY INDUSTRIES, INC.**
**2, Nihonbashi-Muromachi 2-chome Chuo-ku**
**Tokyo 103 (JP)**

(72) Inventor: **Asakura, Toshiyuki**
**B2-13, 2-10, Sonoyama**
**Ohtsu Shiga (JP)**
Inventor: **Mizouchi, Masanori**
**2-33, Oohira**
**Ohtsu Shiga (JP)**
Inventor: **Kobayashi, Hiroaki**
**B3-4, 2-15, Sonoyama**
**Ohtsu Shiga (JP)**

(74) Representative: **Ellis, John Clifford Holgate et al**
**MEWBURN ELLIS & CO. 2/3 Cursitor Street**
**London EC4A 1BQ (GB)**

**EP 0 087 305 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

The present invention relates to a process for production of aromatic polyimide film. More particularly, it relates to an aromatic polyimide film-making process having superior productivity.

Aromatic polyimide film has been known for its excellent heat resistance and electrical as well as mechanical properties, and has been widely used as base film for electric and electronic application, elements for spaceships and many kinds of industrial uses.

Such films of aromatic polyimide are generally made by a dry process from an organic solvent solution of polyamic acid as a precursor thereof.

As to production processes for aromatic polyimide film, there are known as prior art British Patent No. 898651, No. 903271, No. 903272, No. 1155541 and U.S. Patent No. 3179614; disclosed in these patents are methods consisting basically in casting a solution of polyamic acid over a support, treating it for ring closure by heating or by the use of a chemical reagent, then peeling the wet or gel film formed off the support and letting the remaining volatile content of the film vaporize by heating.

These known methods or processes are, however, invariably very low in the solvent removal rate, this resulting in a low productivity, and further some drawbacks, including thermal decomposition of solvent or the like when heated at a high temperature and an increased cost because of the large amount of thermal energy needed, lead to inefficient productivity of film production. Meanwhile, a wet process is disclosed in Japanese Patent Application Laid Open Publication No. 100460/1973 and in its Example 1 is described the following process.

"... This polyamic acid was fed to an extruder of 20 mm diameter preheated to 85°C, and extruded as film through its die under a back pressure of 55 kg/cm$^2$.

The film which was extruded through the die in molten state was led into a water bath placed 25 cm under the die to be wound on a metal drum placed in the lower part of the water bath and, with the water wetting its surface wiped off, led to the heat treating equipment. The temperature of the water bath was controlled at 20°C, and it was so designed that the residence time in water was 3.5 minutes. The film coming out of the water bath was self-supportable and its R.S. (residual solvent content) was 42%. The heat treating equipment was the tenter type, being capable of treating for 1 minute at 200°C and 3 minutes at 350°C. The film obtained had a ring closure ratio of 100%, being a tough polyimide film."

In the described process, however, the extruded film is immediately introduced into water, hence it is difficult to obtain a film of good surface smoothness.

It is an object of the present invention to provide a process for production of aromatic polyimide film of high productivity. Another object of the invention is to provide a process for production of aromatic polyimide film of a high solvent recovery ratio. Still another object of the invention is to provide a process for production of highly stretchable aromatic polyimide film.

The present invention, therefore, relates to a process for production of aromatic polyimide film comprising (A) casting on a support a dope containing an amide-type polar solvent and 10—45 weight percent of polyamic acid and having an inherent viscosity (dl/g) of at least 0.4, (B) concentrating the polymer content to be at least higher than that of the initial dope with simultaneous raising of the ring closure ratio to be higher than 30%, (C) removing the solvent from the film by extraction in an aqueous medium so as to lower the sovlent content of said film to be below 10% and (D) then heating said film to at least 200°C.

The film produced by the process of the present invention is of aromatic polyimide and this may have the recurring structural unit represented by the formula (I) below. The polyamic acid used as a starting material for producing the polyimide film may then have the recurring structural unit represented by the formula (II) below.

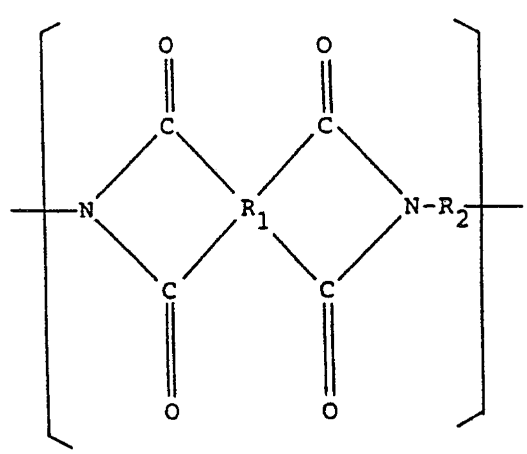

(I)

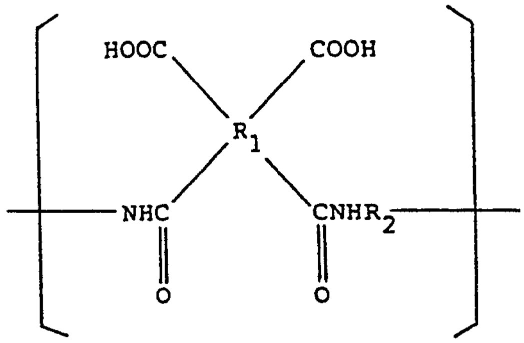

(II)

where $R_1$ is to contain at least one aromatic ring with each pair of carbonyl groups to be bonded into a ring lying on adjacent carbon atoms. The number of carbon atoms in $R_1$, which is quadrivalent, is preferably 6—25.

In the formula $—R_2—$ is a divalent organic group with 6—25 carbon atoms containing at least one aromatic ring. The $R_2$ group may be derived from an aromatic diamine of general formula $H_2N—R_2—NH_2$, and the $R_1$ group from an aromatic tetracarboxylic acid component of general formula

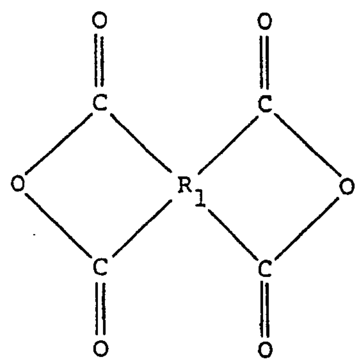

As typical and preferred examples of such an aromatic tetracarboxylic acid component are cited the following.

Pyromellitic dianhydride, 3,3',4,4'-diphenyl tetracarboxylic acid dianhydride, 2,3,6,7-naphthalene tetracarboxylic acid dianhydride, 2,2-bis(3,4-dicarboxyphenyl) ether tetracarboxylic acid dianhydride, pyridine-2,3,5,6 tetracarboxylic acid dianhydride, 3,3',4,4'-benzophenone tetracarboxylic acid dianhydride or tetracarboxylic acid esters thereof.

Pyromellitic dianhydride, 3,3',4,4'-diphenyl tetracarboxylic acid dianhydride and 3,3',4,4'-benzophenone tetracarboxylic acid dianhydride are particularly preferred.

Meanwhile, the preferred aromatic diamine components are those in which two amino groups are not in adjacent positions, which contain at least one aromatic ring as $R_2$ and whose carbon number is 6—25, e.g. p-xylylene diamine, m-phenylene diamine, benzidine, 4,4'-diaminodiphenyl ether, 4,4'-diaminodiphenyl methane, 4,4'-diaminodiphenyl sulphone, 3,3'-dimethyl-4,4'-diaminodiphenyl methane, 1,5-diaminonaphthalene, 3,3'-dimethoxy benzidine and 1,4-bis(3-methyl-5-aminophenyl) benzene, of which 4,4'-diaminodiphenyl ether and m- or p-phenylene diamine are particularly preferred.

Needless to say, a single acid component and a single amine component can be used or there may be mixtures of acid components and/or amine components.

As solvent for polymerization or dope of film-making, there is used a proper amide-type solvent miscible with water, but it is required to have a high dissolving power and to be inert to the polymer. Preferred solvents for the purpose are N,N'-dimethyl acetamide, N,N'-diethyl acetamide, N-methyl-2-pyrrolidone, N-methyl caprolactam, N,N'-dimethyl formamide, tetramethylene sulphone, hexamethyl phosphoramide etc. either alone or in combination, of which particularly preferred are N,N'-dimethyl acetamide and N-methyl-2-pyrrolidone.

The polymer concentration in the dope used in the process of the present invention is required to be 10—45 weight percent, preferably 15-30 weight percent, and said amide-type solvent is preferably present to the extent of 90-55%, but the dope may as well contain other polymers and/or additives.

If the polymer concentration is lower than 10 weight percent, the viscosity of the dope tends to be too low to perform uniform casting thereof, possibly causing uneven film thickness. If, on the other hand, the polymer concentration is higher than 45 weight percent, the viscosity of the dope tends to be too high, possibly causing deterioration of the film's surface smoothness as well as uneven film thickness.

The dope of the present invention may contain suitable additives such as fillers, antioxidizing agents, colouring materials, other polymers and so on. The proper solution viscosity of the dope at the casting temperature is normally 100—20,000 poise (10—2,000 Pa.s) preferably 900—5,000 poise (90—500 Pa.s).

Methods of preparing the polyimide precursor (polyamic acid) as dope for film-making are known. These include preparing polar solvent solution of diamine and adding thereto tetracarboxylic acid dianhydride in powder form at a low temperature (normally 50°C— −10°C, and preferably 30°C— −5°C), or preparing in advance an amine oligomer having a terminal amine group through reaction of excess molar diamine with tetracarboxylic acid and then letting it react with tetracarboxylic acid anhydride in an amount required to make up sufficient molecular weight. The preferred method is to prepare it by the so-called low-temperature solution polymerization method; the imide ring closure ratio of the polymer is desired to be close to zero, preferably less than 5%.

If the ring closure ratio of such a dope is too high, it is likely to cause precipitation or separation of polymer from the dope as well as gelation, and it is difficult to achieve uniform casting or to obtain a uniform film as the final product.

To prevent deterioration of the mechanical properties of the final film and embrittlement of the film in the course of the film-making, it is necessary to keep the molecular weight of the polymer in the dope at more than a specific level, and it is convenient to use inherent viscosity as the measure therefor. Since, if the inherent viscosity ($\eta_{inh}$) is too low, the aforesaid defects are likely to result, the inherent viscosity of the polyimide precursor (polyamic acid) in the solvent must be at least 0.4 dl/g, preferably less than 5.0 dl/g and more preferably 1.0—3.0 dl/g. Also, if the dope viscosity at the time of casting is too low, it is likely to cause ununiformity of casting, and if it is too high, it is likely to cause troubles such as melt fracture, hence it is essential to adjust dope viscosity to a proper level.

The dope of polyimide precursor (polyamic acid) so prepared is cast (or coated) in a film-like layer over a support such as glass or metal plate and then heated usually at more than 40°C and less than 250°C, preferably more than 50°C and less than 200°C, for drying and imidization to proceed. In order to make a self-supportable film and to impart improved mechanical properties to a final film, the polymer concentration of the film after the casting and drying process is required to be at least higher than the initial dope's concentration, preferably 50—80 weight percent, and the imide ring closure ratio of the polymer is required to be more than 30%, preferably 35—90%.

If the polymer concentration is less than that of the initial dope, it is then difficult to obtain a self-supportable film even if the ring closure ratio is raised, and the handling of the film becomes difficult for the subsequent process. Also, if the imide ring closure ratio is less than 30%, the polymer is subject to hydrolysis in the subsequent wet process and heating, this resulting in the final film being embrittled and poor in mechanical properties. To ensure against it, it is usually preferable to control the heating temperature for the cast film in the range of 40—250°C, preferably 50—200°C. If this heating temperature should be below 40°C, too long a time is required for raising the imidization ratio to more than 30% and it is not desirable commercially. When this temperature is above 250°C, bubble formation takes place due to rapid evaporation of the solvent, moreover rapid rise of the imidization rate and rapid hydrolysis are likely to result and it is then, among other things, extremely difficult to control the physical properties of the final film. Needless to say, imide ring closure reaction may be performed by heating as aforesaid, but it may also be done by one of the known alternatives of ring closure reaction such as chemical ring closure by the use of dehydration reagents such as acetic anhydride and/or catalysts such as a tertiary amine for example, pyridine. In the case of chemical ring closure, the ring closure reaction is likely to proceed easier even at low temperatures than in the case of thermal ring closure. When ring closure is effected chemically, it is possibly completed in this stage but that is quite all right. In either case, however, it is necessary that the polymer concentration of the film immediately before it is introduced into an aqueous medium should be at least higher than that of the initial dope.

The self-supportable film with its polymer concentration adjusted by the dry process to more than that of the initial dope and the polymer's imide ring closure ratio to more than 30%, preferably 35—90%, is then immersed in or sprayed with an aqueous medium for extraction of the solvent. By aqueous medium is here meant a liquid mainly composed of water, which is a poor solvent for polymers but has a good affinity for the organic polar amide-type solvent constituting the dope. Liquids usable as aqueous medium are for instance, water, water mixture with amide-type solvent constituting the dope and water mixtures with ethylene glycol, acetone and/or an alcohol with low carbon number, but when the solvent removal rate and solvent recovery ratio are taken into consideration, the ratio of water in aqueous medium is desired to be at least 50%. Also, of those cited above, particularly preferred is water or its mixture with amide-type solvent. The working temperature in the wet process ranges from the freezing point to the boiling point of the aqueous solvent used in the process, generally recommended being 5—90°C. In said wet process, the amide-type organic solvent constituting the dope is to be extracted, and the solvent content of the film just after completion of the wet processing is preferably less than 10% of the weight of polymer, more preferably less than 5%, and an increased residue of the solvent is not desirable, for it means an increased decomposition loss of the solvent in the step of the subsequent heat treatment. The conditions for controlling the solvent content below 10% are determined by the time of immersion in the bath of the wet processing, bath temperature and the film thickness etc. and in order to obtain a uniformly coagulated film by the wet process, it is advisable to arrange for gradual progress of the coagulation of the polymer by the

use of a multibath for inhibiting sudden precipitation of the polymer in a gel state film. Still more preferred is carrying out stretching of film in this stage for improvement of its final mechanical properties. With the film in a state swollen by the aqueous solvent, it is easy to stretch in a relatively low temperature range of 5—90°C.

After completion of the wet processing the film is to be heat-treated for removal by vaporization of the aqueous medium as well as of the small residual amount of amide-type solvent and also for completion of imidization of the polymer by raising the ring closure ratio to more than 90% if necessary. The temperature of this heating stage is required to be at least 200°C, preferably in the range of 230°C to 700°C, and if it is lower than that, such inconveniences result as insufficient ring closure and too long a time required for removal of the volatiles of the film. Considering the final hygroscopic property and mechanical properties of the film, it is necessary to raise the imide ring closure ratio to more than 90% in the process if it should be still less than this figure. Hence the heating temperature in this stage is required to be at least 200°C. Also, it is preferred to heat the film under tension in this stage, but is quite all right if stretching, relaxing, etc., should be performed as necessary.

In the process of the present invention, the practically non-closed polyamic acid in the dope is closed to more than a specific level of ring closure ratio and thereafter the solvent removal is done in an aqueous medium under high polymer concentration and furthermore a film is obtained by heating at a temperature more than a specific level. Therefore, it brings the following outstanding features. That is, while by the conventional, so-called dry process without water extraction, the residual solvent in the film is almost completely decomposed or vaporized in the subsequent stage of heat treatment and is difficult to recover, the wet process of the present invention is free from decomposition of the residual solvent and the greater part thereof is recoverable, this resulting in an increased productivity. Further, the film swollen in the course of wet processing is easy to stretch and a film of outstanding mechanical properties can be obtained with ease. Furthermore, the solvent removal rate in the wet process is generally higher than in solvent removal by heating, this resulting in advantages of high film-making rate and greater ease with which thick films are obtained.

The imide ring closure ratio referred to in the present invention is calculated by the following formula with said ratio as 0 when the polymer consists solely of polyamic acid and 100 when the polymer is perfectly converted into polyimide. Perfect conversion into polyimide is here defined to be the case when a film of polyamic acid heated for 30 minutes at 300°C.

$$\text{Ring closure ratio (\%)} = \frac{\text{(No. of imide rings closed)}}{\text{(No. of imide rings closed)} + \text{(No. of amic acid units in the polymer available for closing but still unclosed)}} \times 100$$

This value is obtainable by mechanical analysis methods such as IR absorption spectrum and NMR spectrum or by an acid value measuring method. In the given examples of the present invention the imide ring closure ratio was calculated from 720 $cm^{-1}$ (imide ring absorption) and 875 $cm^{-1}$ (p-substituted phenyl absorption) of IR absorption spectrum.

The inherent viscosity ($\eta_{inh}$) referred to in the present invention is calculated by the following formula with 0.5 g/100 ml N-methyl-2-pyrrolidone as solvent at 30°C by the use of an Ubelode-type viscometer.

$$\eta_{inh}\ (dl/g) = \frac{\log \dfrac{\text{Flow time of solution}}{\text{Flow time of solvent}}}{\text{Concentration}}$$

Described below are typical preferred examples of the present invention. In these examples parts given are by weight.

### Example 1

26 parts of 4,4'-diaminodiphenyl ether were dissolved in 231 parts of dehydrated N,N'-dimethyl acetamide. Then 28.4 parts of pyromellitic acid dianhydride in powder form were added gradually at 15°C under stirring. The viscosity of the dope increased progressively with increasing addition of the pyromellitic acid and when stirring was continued for 1 hour after completion of its addition, polyamic acid having almost zero imide ring closure ratio was obtained, and the resulting dope showed an inherent viscosity ($\eta_{inh}$) of 1.5 and a solution viscosity of 1,300 poises. The polymer concentration of this dope was 19%. Then this dope was uniformly cast over a glass plate by the use of a doctor knife adjusted to a gap of 150 µm, and it was kept for 15 minutes in a hot air oven heated to 140°C. A pale yellow, self-supportable film with an imide ring closure ratio of 52% was obtained. Then the film was peeled-off and it was immersed for 5 minutes in running water of 20°C, the residual amount of dimethyl acetamide in the film being 1% of the

weight of the polymer as measured by gas chromatographic analysis. When this film was set on a frame and heated for 2 minutes at 200°C and for 7 minutes at 300°C, polyimide film (thickness: 28 μm) close to 100% in imide ring closure ratio was obtained. The physical properties of this film are shown below in Table 1 together with the control example described below.

Now a control example was made, as described hereunder, to show that a film lower in imide ring closure ratio is inferior when it is made by dry wet process.

The polyamic acid dope polymerized in Example 1 was cast over a glass plate also by the use of an applicator and it was kept for 20 minutes in an oven of 75°C for drying and for imidization to proceed. The polymer concentration of the film peeled off the glass plate was 52%, but the imide ring closure ratio was low at 14%. When the film so obtained was similarly treated in running water for 10 minutes for solvent removal to reduce the residual solvent ratio to 1% and was heated with its length kept constant for 2 minutes at 200°C and 7 minutes at 300°C for preparation of a polyimide film it was embrittled and easy to tear. Its physical properties are shown also in Table 1.

TABLE 1

| Physical property | Example | Control Example 1 |
|---|---|---|
| Imidization ratio (%) immediately after dry process | 52 | 14 |
| Polymer concentration (%) immediately after dry process | 70 | 52 |
| Residual solvent ratio (%) immediately after wet process | 1 | 1 |
| Strength (kg/mm$^2$) of film | 23 | 3 |
| Elongation (%) | 80 | 2 |
| Young's modulus (kg/cm$^2$) | 316 | 300 |
| Folding endurance (MIT) (times) | 30,000 | 50 |

Example 2

20 parts of 4,4′-diaminodiphenyl ether were dissolved in 133.4 parts of N-methyl-2-pyrrolidone and to the solution 25 parts of 3,3′,4,4′-diphenyl tetracarboxylic acid dianhydride were added in powder form under cooling to 10°C and under stirring and the mixture was then stirred further for 30 minutes.

Then a solution of 2.2 parts of 3,3′,4,4′-diphenyl tetracarboxylic acid dianhydride in 8.2 parts of N-methyl-2-pyrrolidone was added dropwise to the mixture until the reaction was completed. The resulting dope was 25% in polymer concentration, $\eta_{inh}$=0.95 and 2,000 poises in solution viscosity. This dope was debubbled and then extruded through a slit of 200 μm by a gear pump onto an SUS plate, then it was dried for 10 minutes in a hot air oven of 120°C and a pale yellow self-supportable film with an imide ring closure ratio of 40% and polymer concentration of 65% was obtained. This film was immersed for 3 minutes in a 10°C bath of 80% water and 20% N-methyl-2-pyrrolidone, stretched 1.5 times in one direction and treated 1 minute in running water for solvent removal and a film 1.5% in residual solvent ratio was thus obtained. This film was heated with its length kept constant for 3 minutes at 150°C and 330°C respectively and 25 μm thick polyimide films more than 97% in imide ring closure ratio were thus obtained. The films obtained were pale yellow, transparent and tough with a strength of 35 kg/mm$^2$ in the stretched direction and 12 kg/mm$^2$ in the transverse direction.

For comparison the same dope was cast on to an SUS plate and it was kept immersed in the same bath and then treated in running water without the concentration step or ring closure step. However, the precipitation of the polymer took place early in the course of wet processing and the resulting film was very brittle and was white turbid with no practical value.

Example 3

14.28 parts of 3,3′,4,4′-benzophenone tetracarboxylic acid dianhydride were dissolved in a 1/1 (by weight) mixed solvent of N-methyl-2-pyrrolidone and N,N′-dimethyl acetamide and to the solution 13.86 parts of 4,4′-diaminodiphenyl methane were added in powder form under stirring at 10°C, this being followed by stirring for a further 3 hours. The resulting polyamic acid dope was about 0 in ring closure ratio, $\eta_{inh}$=1.1, 33% polymer concentration and 4,500 poises in solution viscosity.

This dope was cast on to an SUS plate in the same manner as described in Example 2, heated for 10

minutes at 130°C for the polymer concentration to be increased to 57% with the imide ring closure ratio adjusted to 45% and was then immersed for 5 minutes in a water bath of 20°C for solvent removal, and thus a film with 2% residual solvent was obtained. Then, when this film was heated for 2 minutes at 220°C with its length kept constant, its volatiles content was less than 1%. A 35 μm thick film about 100% in imidization ratio was obtained after being heated for 3 minutes at 300°C. The strength and elongation of this film were 15 $kg/mm^2$ and 18% respectively and the time required for film-making by this method was 20 minutes. To compare it with the film-making time in the pure dry process, the above film just before immersion into a water bath was heated for 15 minutes at 220°C with its length kept constant, and the film was then found still to contain 33% solvent of the weight of the polymer, this indicating very slow progress of evaporation.

It was only after heating for further 7 minutes at 300°C that a 35 μm film reached less than 1% in volatiles content and about 100% in imide ring closure ratio. The time required for film-making by this dry process was 32 minutes, 1.5 times longer than by the process of the present invention and it was revealed that solvent up to 33% of the polymer weight was irrecoverable.

**Claims**

1. A process for production of aromatic polyimide film comprising (A) casting on a support a dope containing an amide-type polar solvent and 10-45 weight percent of polyamic acid and having an inherent viscosity (dl/g) of at least 0.4, (B) concentrating the polymer content to be at least higher than that of the initial dope with simultaneous raising of the ring closure ratio to be higher than 30%, (C) removing the solvent from the film by extraction in an aqueous medium so as to lower the solvent content of said film to be below 10% and (D) then heating said film to at least 200°C.

2. A process for production of aromatic polyimide film as claimed in claim 1, wherein the inherent viscosity of said polyamic acid is less than 5.0.

3. A process for production of aromatic polyimide film as claimed in claim 1, wherein said polyamic acid is that derived from pyromellitic acid dianhydride and 4,4'-diaminodiphenyl ether.

4. A process for production of aromatic polyimide film as claimed in any preceding claim, wherein the concentration of said polymer in said (B)-stage is more than 50 weight percent.

5. A process for production of aromatic polyimide film as claimed in any preceding claim, wherein said amide-type polar solvent is selected from N,N'-dimethyl acetamide and N-methyl-2-pyrrolidone.

6. A process for production of aromatic polyimide film as claimed in any preceding claim, wherein the ring closure ratio of the said polymer in the (B)-stage is 35—90%.

7. A process for production of aromatic polyimide film as claimed in any preceding claim, wherein said aqueous medium is water or a mixture of more than 50 weight percent of water with said amide-type solvent.

8. A process for production of aromatic polyimide film as claimed in any preceding claim, wherein the heating temperature in the (D)-stage is in a range of 230—700°C.

9. A process for production of aromatic polyimide film as claimed in any preceding claim, wherein ring closure in the (B)-stage is done chemically.

10. A process for production of aromatic polyimide film as claimed in claim 9, wherein acetic anhydride and tertiary amine are used for said chemical ring closure.

**Patentansprüche**

1. Verfahren zur Herstellung einer aromatischen Polyimidfolie, welches umfaßt: (A) Gießen einer Flüssigkeit, die ein polares Lösungsmittel vom Amid-Typ und 10 bis 45 Gew-% eines Polysäureamids enthält und eine Eigenviskosität (dl/g) von mindestens 0,4 aufweist, auf einen Träger, (B) Konzentration des Polymergehaltes, sodaß er zumindest höher als der der Ausgangsflüssigkeit ist, wobei gleichzeitig das Ringschlußverhältnis auf höher als 30% erhöht wird, (C) Entfernung des Lösungsmittels aus der Folie durch Extraktion in einem wässrigen Medium, um den Lösungsmittelgehalt dieser Folie auf unter 10% zu verringern und (D) anschließendes Erwärmen dieser Folie auf mindestens 200°C.

2. Verfahren zur Herstellung einer aromatischen Polyimidfolie nach Anspruch 1, worin die Eigenviskosität des Polysäureamids weniger als 5,0 beträgt.

3. Verfahren zur Herstellung einer aromatischen Polyimidfolie nach Anspruch 1, worin das Polysäureamid von Pyromellitsäure-dianhydrid und 4,4'-Diaminodiphenylether abgeleitet wurde.

4. Verfahren zur Herstellung einer aromatischen Polyimidfolie nach einem der vorstehenden Ansprüche, worin die Konzentration des Polymers in der Stufe (B) größer als 50 Gew-% ist.

5. Verfahren zur Herstellung einer aromatischen Polyimidfolie nach einem der vorstehenden Ansprüche, worin das polare Lösungsmittel vom Amid-Typ aus N,N'-Dimethylacetamid und N-Methyl-2-pyrrolidon ausgewählt ist.

6. Verfahren zur Herstellung einer aromatischen Polyimidfolie nach einem der vorstehenden Ansprüche, worin das Ringschlußverhältnis des Polymers in der Stufe (B) 35 bis 90% beträgt.

7. Verfahren zur Herstellung einer aromatischen Polyimidfolie nach einem der vorstehenden Ansprüche, worin das wässrige Medium Wasser oder eine Mischung von mehr als 50 Gew-% Wasser mit dem Lösungsmittel vom Amid-Typ ist.

8. Verfahren zur Herstellung einer aromatischen Polyimidfolie nach einem der vorstehenden Ansprüche, worin die Erwärmungstemperatur in der Stufe (D) im Bereich von 230 bis 700°C liegt.

9. Verfahren zur Herstellung einer aromatischen Polyimidfolie nach einem der vorstehenden Ansprüche, worin der Ringschluß in der Stufe (B) chemisch vorgenommen wird.

10. Verfahren zur Herstellung einer aromatischen Polyimidfolie nach Anspruch 9, worin zum chemischen Ringschluß Essigsäureanhydrid und tertiäres Amin verwendet werden.

**Revendications**

1. Procédé de production d'un film de polyimide aromatique comprenant (A) la coulée sur un support d'un enduit contenant un solvant polaire du type amide et de 10 à 45% en poids d'acide polyamique et présentant une viscosité inhérente (dl/g) d'au moins 0,4, (B) l'augmentation de la concentration du polymère de mainère à ce qu'elle soit au moins supérieure à celle de l'enduit initial en amenant simultanément le rapport de cyclisation au-dessus de 30%, (C) l'élimination du solvant du film par extraction dans un milieu aqueux de manière à abaisser la teneur en solvant du film au-dessous de 10%, puis (D) le chauffage du film à au moins 200°C.

2. Procédé de production d'un film de polyimide aromatique selon la revendication 1, dans lequel la viscosité inhérente de l'acide polyamique est inférieure à 5,0.

3. Procédé de production d'un film de polyimide aromatique selon la revendication 1, dans lequel l'acide polyamique est celui dérivé du dianhydride d'acide pyromellitique et de l'éther de 4,4'-diaminodiphényle.

4. Procédé de production d'un film de polyimide aromatique selon l'une quelconque des revendications précédentes, dans lequel la concentration du polymère dans l'étape (B) est supérieure à 50% en poids.

5. Procédé de production d'un film de polyimide aromatique selon l'une quelconque des revendications précédentes, dans lequel le solvant polaire du type amide est choisi parmi le N,N'-diméthyl acétamide et la N-méthyl-2-pyrrolidone.

6. Procédé de production d'un film de polyimide aromatique selon l'une quelconque des revendications précédentes, dans lequel le rapport de cyclisation du polymère dans l'étape (B) est compris entre 35 et 90%.

7. Procédé de production d'un film de polyimide aromatique selon l'une quelconque des revendications précédentes, dans lequel le milieu aqueux est l'eau ou un mélange contenant plus de 50% en poids d'eau avec le solvant du type amide.

8. Procédé de production d'un film de polyimide aromatique selon l'une quelconque des revendications précédentes, dans lequel la température de chauffage dans l'étape (D) est comprise entre 230 et 700°C.

9. Procédé de production d'un film de polyimide aromatique selon l'une quelconque des revendications précédentes, dans lequel on effectue chimiquement la cyclisation dans l'etape (B).

10. Procédé de production d'un film de polyimide aromatique selon la revendication 9, dans lequel on utilise de l'anhydride acétique et une amine tertiaire pour la cyclisation chimique.